# EUROPEAN PATENT SPECIFICATION

(11) **EP 1 825 225 B1**
(45) Date of publication and mention of the grant of the patent: **27.04.2016**
(21) Application number: 05818603.2
(22) Date of filing: 15.12.2005
(51) Int. Cl.: G01D 5/20, G01D 5/22

(54) **INDUCTIVE DETECTOR**
INDUKTIVDETEKTOR
DETECTEUR INDUCTIF

(30) Priority: 15.12.2004 GB 0427417; 20.12.2004 GB 0427760; 23.12.2004 GB 0428124; 16.02.2005 GB 0503178; 22.02.2005 GB 0503595; 30.03.2005 GB 0506375; 07.07.2005 GB 0513936; 08.08.2005 GB 0516215; 22.08.2005 GB 0517134
(43) Date of publication of application: 29.08.2007
(73) Proprietor: Howard, Mark Anthony, Worlington, Suffolk IP28 8SQ (GB); Kreit, Darran, Foxton Cambridgeshire CB2 6RY (GB)
(72) Inventor: Howard, Mark Anthony, Worlington, Suffolk IP28 8SQ (GB); Kreit, Darran, Foxton Cambridgeshire CB2 6RY (GB)
(74) Representative: ip21 Ltd
(86) International application number: PCT/GB2005/004854
(87) International publication number: WO 2006/064245

(56) References cited:
- GB-A- 2 394 293
- US-A- 4 737 698
- US-A- 6 011 389
- US-A1- 2002 043 972

## Description

### Field of the Invention

This invention relates to inductive detectors and contactless transmission of electrical power and signals.

### Review of the Art known to the Applicant

Various forms of inductive detector have been used to measure the position of two relatively moveable bodies. They are variously referred to as detectors, sensors, transducers, encoders, measurement devices or systems. Some specific forms may be referred to as Inductosyns, resolvers, synchros and linearly variable differential transformers (LVDT's).

Nevertheless, the use of inductive techniques in mass market detectors has been limited. This is mainly due to relatively high manufacturing costs and limited measurement performance.

An inductive detector chiefly comprises two main elements: an electrical intermediate device (EID) and an antenna which are typically arranged to move in a single axis (it is important to note that this invention is not restricted to measurement in a single axis). The antenna is energized by an electronic circuit which processes the received signals. The electronic circuit outputs electrical data in accordance with the relative position of the EID and antenna. The antenna typically contains transmit windings arranged along the axis of movement. An alternating electromagnetic field is formed around the transmit windings. When the EID enters this electromagnetic field, currents are induced to flow in its circuit. These currents can be sensed directly using a search coil placed within the field - as used by Inductosyn or inductive probe methods. Alternatively a passive, unconnected EID may be used which, in turn, generates its own alternating electromagnetic field. This field induces a signal in the antenna's receive circuits which is indicative of the EID's position relative to the antenna.

Construction of detectors generally using the aforementioned technique was disclosed by McMullen et al. in US 4,737,698. This technique partly took over from the measurement technique described as Inductosyn which was limited by its requirement for electrical connections to the both moving and stationary parts. In the McMullen disclosure, a conductive disk moves relative to a planar array of transmit and receive windings. As the disk moves, it changes the mutual inductance between the windings producing an electrical analogue of the disk's position. The method is limited by weak signal strengths and the need for the conductive disk to remain close to the antenna. This type of system can produce excessive emissions in an effort to generate higher signal amplitudes from higher power transmit signals. Furthermore, such systems suffer from relatively poor electromagnetic susceptibility and low signal: noise ratios.

Higher signal strengths may be achieved by using electrically resonant EIDs. The earliest mention of resonant EIDs, known to the authors, is described in patent JP 52-57727 for a character designating device.

Resonant EIDs co-operating with an antenna are to be found in an automatic meter reading system from Sensus Water Meters Inc., USA, in which each wheel of a meter's odometer rotates relative to a transmit and receive winding. The technique is described in WO 94/25829. According to the phase and frequency of the electronic signature from each of the wheels, the odometer count can be measured remotely by a reader. The method has not been used more extensively because it is only really suitable for odometer style arrangements.

The potential advantages of inductively resonant EIDs co-operating with antennae has previously been recognised by the authors in various earlier disclosures (e.g. GB 0217745.9). To date, these inventions have not generated significant mass market products due to modest performance relative to high production costs. High costs are partly attributable to sophisticated electronics or the use of complex antennae and EID constructions using multi-layer printed circuit boards (PCB's) with relatively large numbers of fine diameter plated via holes. These via holes are expensive to produce; impose space and layout limitations on detector design and interfere with the magnetic field patterns. Measurement performance is limited due to a number of factors including capacitive coupling between transmit and receive circuits; limited measurement resolution; relatively low signal: noise ratios and susceptibility to electromagnetic emissions. Furthermore, applications to date have mostly been limited to measurement of gross displacements typically>1mm. Consequently, measuring a user's very light touch on a user interface has not been practical.

The application of inductive detectors, and measuring instruments more generally, in extreme or aggressive environments has been restricted by the requirement to supply them with power and receive data from them. In benign environments this is a trivial matter, usually solved by a simple electric cable. In some environments (e.g. potentially explosive areas; nuclear radiation areas or inside pressure vessels) the provision of a cable interconnection is not straightforward and requires significant effort and cost to construct seals and leak-poof connectors. Whilst batteries and wireless communications are possible in some applications, they are not universally applicable.

Other relevant prior art documents are briefly discussed below.

US6011389 discloses an inductive transducer system for use in high accuracy applications such as linear or rotary encoders which employs two members movable relative to each other. A first, active member induces eddy currents in a second, passive member that lacks a power source or electrical wires connected thereto. The first, active member contains both a transmitter for generating a magnetic field and a receiver for receiving the field. The receiver has a plurality of symmetric loops. Electronic circuitry coupled to the receiver evaluates the relative position between the two members as the passive member disrupts the magnetic field received by the receiver. The inductive transducer can be readily manufactured using known printed circuit board technology, and is substantially immune to contamination by particles, including ferromagnetic particles, oil, water and other fluids. A pulse-driven drive circuit allows the inductive transducer to consume little power, and thus allows the transducer to be readily incorporated into hand-held, battery-powered measurement tools.

US2002/043972 discloses an inductive linear position sensor, particularly for use with motor vehicles has an oscillator circuit for creating a periodic alternating voltage signal, an exciting coil coupled to the oscillator circuit, a plurality of receiving coils with the exciting and receiving coils being structured as leads on a circuit board, evaluation circuitry for evaluating signals induced in the receiving coils and a movable inductive coupling element for influencing the strength of inductive coupling between the exciting coil and the receiving coils. The evaluation circuitry is arranged within the geometry of at least one of the sending (exciting) and receiving coils. Effective surface areas of the receiving coils are structured at beginning and end areas of the sensor such that, when there is no movable element present, a zero voltage results at the output taps of the receiving coils.; The structure of the sensor compensates for offset voltages, which are created by asymmetrical positions of the receiving coils to the exciting coil as well as for components of the evaluation circuitry.

GB2394293 discloses a sensor for measuring a physical parameter, for example relative position, comprising a signal generator which generates an excitation signal at a given frequency which is applied to at least one excitation winding, a sensor winding inductively coupled to the excitation winding and a signal processor which processes sensed signals in the sensing winding. The signal processor mixes or beats the sensed signals with a second signal of different frequency to produce a third signal. The value of the parameter is determined from the phase of the third signal. The sensor winding may be electromagnetically coupled to the excitation winding via a resonator such as an LC circuit. Other parameters that may sensed include relative position in two or three dimensions, orientation, temperature or humidity.

### Summary of The Invention

This invention provides an inductive detector as set out in the accompanying claims.

### Brief Description of the Drawings

Figure 1 shows an exploded view of a known form of planar inductive antenna.
Figure 2 shows a simplified schematic of a known form of inductive antenna constructed using a 2 layer printed circuit board (PCB).
Figure 3 shows a schematic of the invention's antenna.
Figure 4 shows a method of constructing conductor cross-overs on the antenna.
Figure 5 shows a schematic of an edge connector for use on an antenna.
Figure 6 shows a schematic of an antenna co-operating with an EID.
Figure 7 shows a schematic of a known form of position encoder with a sophisticated electronics circuit.
Figure 8 shows a schematic of a known form of position encoder with a simplified electronics circuit.

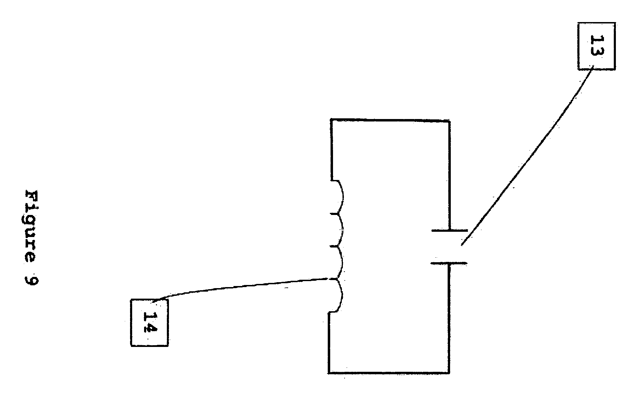

Figure 9 shows a schematic of a resonant circuit.
Figure 10 shows a schematic of a resonant circuit with a normally open switch.
Figures 11a, 11b & 11c show schematic methods of encoding identities on to EIDs.
Figures 12a & 12b show schematics of encoding identities using the relative displacements of multiple EIDs.
Figure 13 shows an antenna construction using only a few via holes and windings each of which is substantially on a single layer of PCB.
Figure 14 shows an arrangement of an inductor and a core.
Figure 15 shows a sectional arrangement of an inductor and a core.
Figure 16 shows an arrangement of a rotary user element, EID and an antenna used in the detection of a user's touch and movement
Figure 17 shows an arrangement of a linear user element, EID and an antenna used in the detection of a user's touch and movement.
Figure 18 shows an electrical schematic of a user element and EID used in the detection of a user's touch and movement.

### Detailed Description of the Drawings

In a first embodiment, the invention provides an inexpensive but high performance inductive detector.

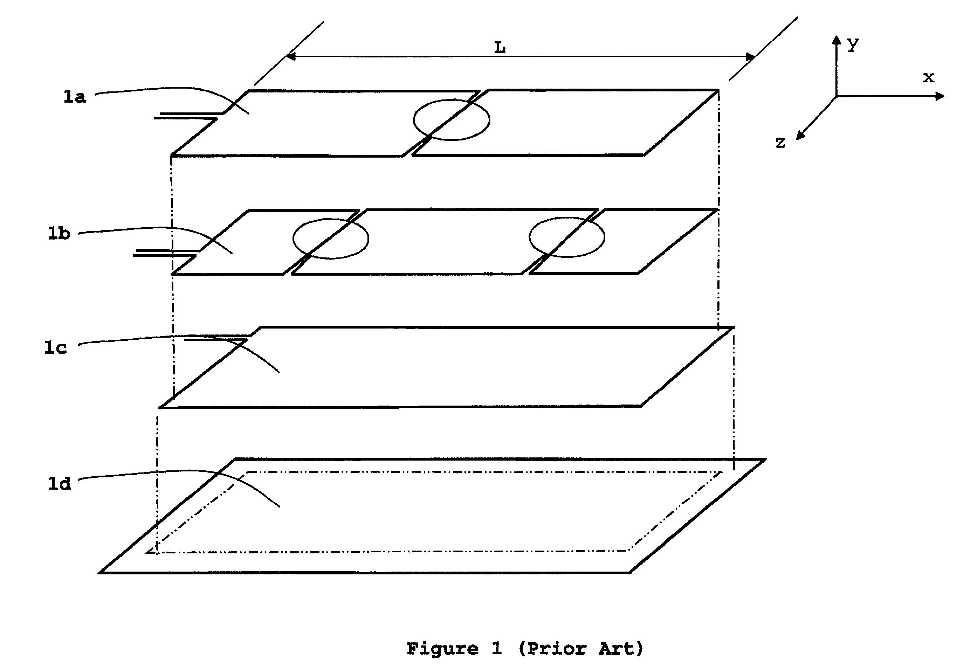

Figure 1 shows an exploded view of a known form of planar inductive antennae. Such forms typically contain two receive windings [1a and 1b] inside a transmit winding [1c]. The receive windings [1a & 1b] are spaced apart along the measurement path [x-axis] by a distance of L/4 where L is their winding pitch. An alternating electromagnetic field is formed around the transmit winding [1c] when it is energized. The transmit winding [1c] and receive windings [1a & 1b] are balanced with respect to each other so no net signal appears at the receive windings [1a & 1b] without an EID [6].

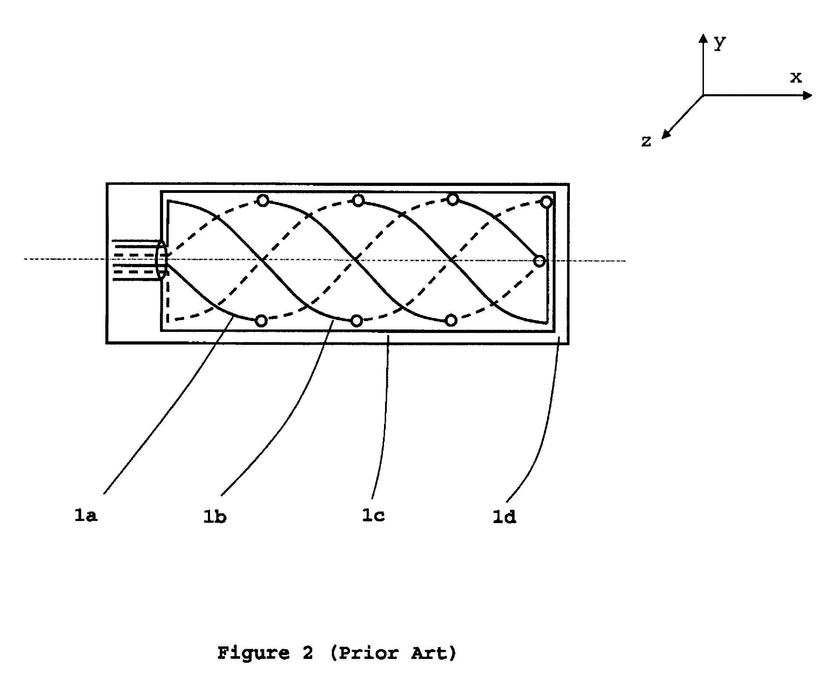

Figure 2 shows a simple, practical construction of the antenna schematic shown in Figure 1 in which the various windings [1a, 1b & 1c] are formed as tracks on the surfaces of a 2 layer PCB [1d]. The layers of the PCB [1d] are connected using first and second groups of plated via holes as shown. There are a number of significant problems with this construction. Firstly, the via holes are expensive to produce due to the need for accurate drill positioning and through plating. Second, the production yield of PCB's with lots of via holes is reduced because of the imperfect nature of the via hole drilling and plating process. Third, the use of plated vias limits the choice of the PCB substrates to the more costly forms such as FR4 grade rather than the lower cost forms such as CEM1 (which cannot easily be produced with plated vias). Fourth, the vias distort the alternating magnetic field in proportion to their size. Fifth, via holes are problematic in applications which have extreme temperature cycles since they are prone to thermal cracking or fatigue. Sixth, the smaller the via hole, the greater the production cost and small via holes are preferable in an inductive detector design because they produce minimum magnetic distortion. Seventh, it is not practical to drill small diameter via holes in thick PCB substrates (which may be desirable for mechanical purposes) because long and thin drill bits are prone to snapping. Eighth, overlapping transmit and receive windings on the various surfaces of the PCB [1d] produces capacitive coupling between the otherwise electrically insulated windings (this reduces the detector's signal: noise ratio). Ninth, via holes are a dirt trap which means that wipe clean or readily disinfected antennae [1] surfaces are not practical. Tenth, detectors of this type often require multiple turns in each winding loop as well as multiple pitches. In such multi-turn constructions >100 vias per antenna [1] may be required. Such a high number of vias places a significant constraint on detector design especially in small detectors.

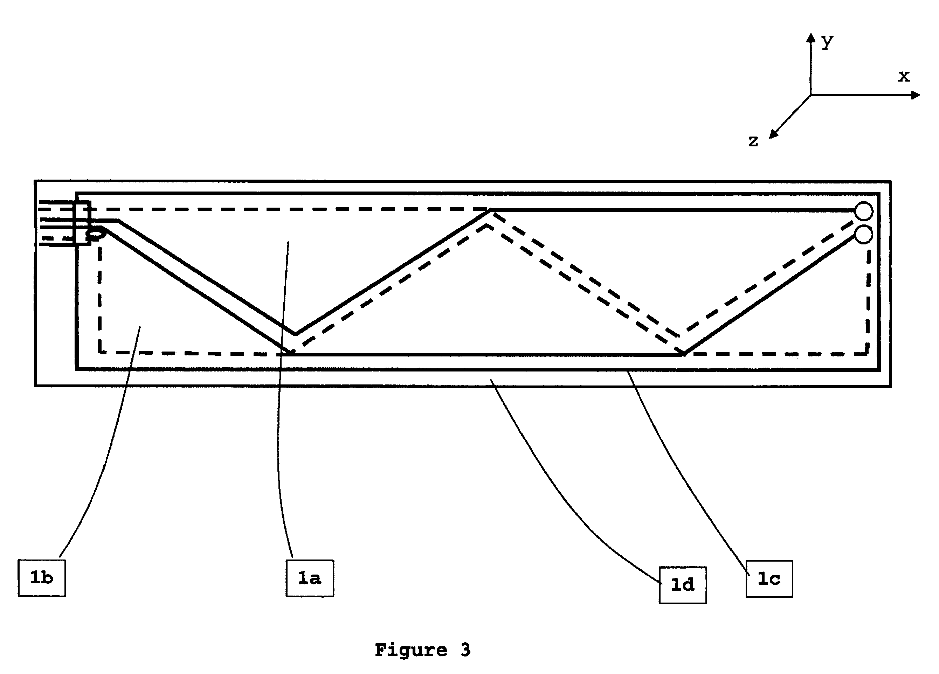

Figure 3 shows a first embodiment of the invention which provides an inexpensive, high performance inductive antenna. As shown in Figure 3, a transmit winding [1c] surrounds two receive windings [1a & 1b]. The windings are formed as conductive tracks on a two sided PCB [1d]. The receive windings [1a & 1b] are spaced apart along the measurement path (i.e. the x-axis) and at right angles to the measurement path (i.e. the y-axis). In the x-axis the receive windings [1a & 1b] are spaced apart by a distance of L/4 where L is their winding pitch. In the y-axis, the receive windings [1a & 1b] are spaced so that they are interdigitated but do not overlap. The transmit winding [1 c] is energised with an AC signal from the remote electronics circuit [not shown for clarity] and a field is formed around it It is important to note that the transmit [1c] and receive windings [1a & 1b] are substantially balanced with respect to each other so that no net signal appears at the receive windings [1a & 1b] in the absence of the EID. The receive windings [1a & 1b] may be considered as a sine and cosine winding due to their L/4 displacement - thus affording the potential for position calculation using a simple arctan computation. As can be seen, each of the receive windings [1a & 1b] is formed by a first convoluted conductor extending along the measurement path on the PCB's [1d] upper face returning back along the measurement path on the PCB's [1d] lower face. The convoluted conductor forms a series of loops in each receive winding [1a & 1b] so that adjacent loops in each series have opposite electromagnetic polarity. The width of each loop varies along the measurement axis. The receive windings [1a & 1b] are connected between layers using one via hole per receive winding [1a & 1b]. Only one via hole is required per receive winding [1a & 1b] and this is situated at the end of the linear antenna [1]. Advantageously, the extreme ends of a linear encoder are typically not used due to non-linear end effects. The via may be relatively large or simply an unplated hole with a soldered pin from one side of the PCB to the other. Since there is no overlap of the windings there is minimal capacitive coupling.

Deviations from a linear function of mutual inductance with respect to x-axis displacement can be simply corrected for in software since they depend only on the known shape of the windings.

The construction shown in Figure 3 improves detector performance and reduces the manufacturing cost due to a number of advantages: the non-overlapping layout of the windings; increased selection of inexpensive PCB laminate materials; reduced number of vias; advantageous via hole positioning.

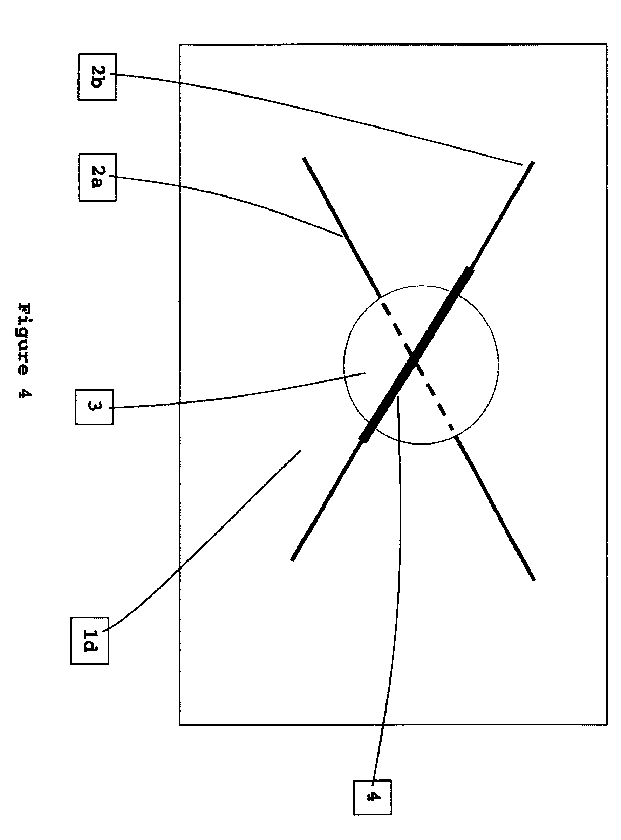

Figure 4 shows a cross over (rather than a via) on a single layer PCB. A first winding portion [2a] is continuous and deposited on an insulating substrate [1d]. A second circuit portion [2b] is split so as to maintain electrical isolation from the first part. A layer of insulating coating [3] is deposited over the immediate area. A link is formed between the two parts of the split conductor [2b] by a conductive strip [4]. Alternatively, the link may be formed by a number of other means including a link of copper wire soldered in place onto pads or a zero ohm resistor. This technique enables the use of a broad range of substrate materials which would not normally be considered suitable for planar inductive antennae such as glass, ceramic, moulded or cast plastic.

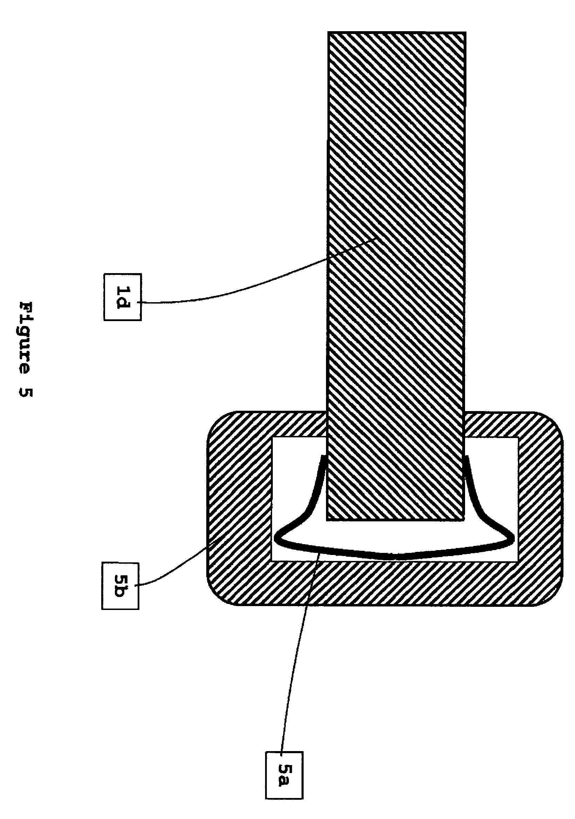

Figure 5 shows a further technique to eradicate plated via holes. A link at the edge of the antenna [1] is formed between the two faces of PCB [1d] by an edge connector. The edge connector comprises a plastic moulded housing [5b] containing a sprung copper lead [5a].

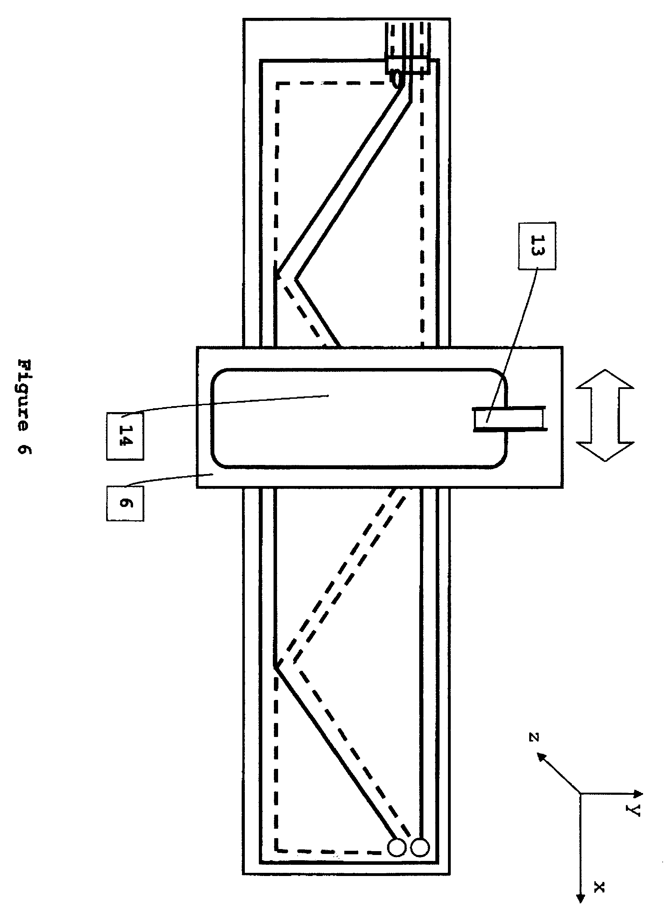

Compared to traditional constructions, in which receive windings [1a & 1b] overlap each other, this construction has greater sensitivity to offsets of the EID in the y-direction. This undesirable sensitivity can be minimised very simply be extending the area of the EID [6] in the y-axis so that it overlaps the effective edges of the antenna. Figure 6 schematically shows the antenna layout co-operating with a resonant EID [6] comprising an inductor [14] and capacitor [13] in electrical series.

Figures 3 and 6 show the receive windings [1a & 1b] in the shape of simple triangles. As will be appreciated by those skilled in the art, this is not necessary for successful operation. Instead, the windings may be formed from conductors arranged as a sinusoid, a curve or a series of straight lines. If triangles are used, the output will not be linear and the electrical output will contain higher order effects. The biggest non-linearity will be a fourth harmonic effect which may be in excess of 2% of full-scale. This can be remedied by arranging a notch at the centre of each peak of sufficient width to bring the linearity down to <0,5%. In the main, non-linearity will be due to higher harmonics. Their high order means that the fundamental sensitivity curve is not as uniform as it might be. This undesirable effect may be simply reduced by using a larger gap between the antenna [1] and EID windings or by using curved winding shapes. As with traditional constructions there are the usual issues of non-linearity at the ends (smooth cubic-like curve) and both receive windings [1a & 1b] need to be balanced to the transmit windings [1c]. Both issues may be solved by extra loops at the ends of the receive windings [1a & 1b].

As with known antennae constructions, EMC emissions and immunity levels may be improved by the provision of additional balancing loops away from the measurement area.

Various methods of EID or antennae [1] construction are feasible. These include - but are not limited to - double sided printed circuit board with plated through holes; ultrasonic bonding of insulated copper wire on to an insulated substrate; printed conductive ink on an insulating substrate; sewing of copper wire on to an insulated substrate; the deposition of conductive tracks on to a silicon substrate; windings laser cut or stamped and then folded from sheet metal such as copper, aluminium or steel.

The invention is not restricted to using passive EIDs. In an alternative 'active' arrangement the transmit [1c] and receive windings [1a & 1b] are arranged for relative movement and no EID [6] is used. In such an arrangement the transmit winding [1c] is formed by a coil which moves in a path above the receive windings [1a & 1b]. This kind of arrangement is most advantageous where there is limited space; where signal strengths need to be maximised and where the provision of connecting wires to the moving part provides no particular problem, e.g. a curvi-linear encoder with limited travel pivoting from a central axis.

### Second Embodiment

PCB's are a useful material or technique to produce antennae [1] and EIDs in this invention. Nevertheless, as described previously, the use of double sided PCB's for these components has some significant limitations due to the necessary use of plated through holes or cross overs. This second embodiment of the invention enables an antenna design with relatively few via holes or cross overs - all of which may be produced in a single straight line.

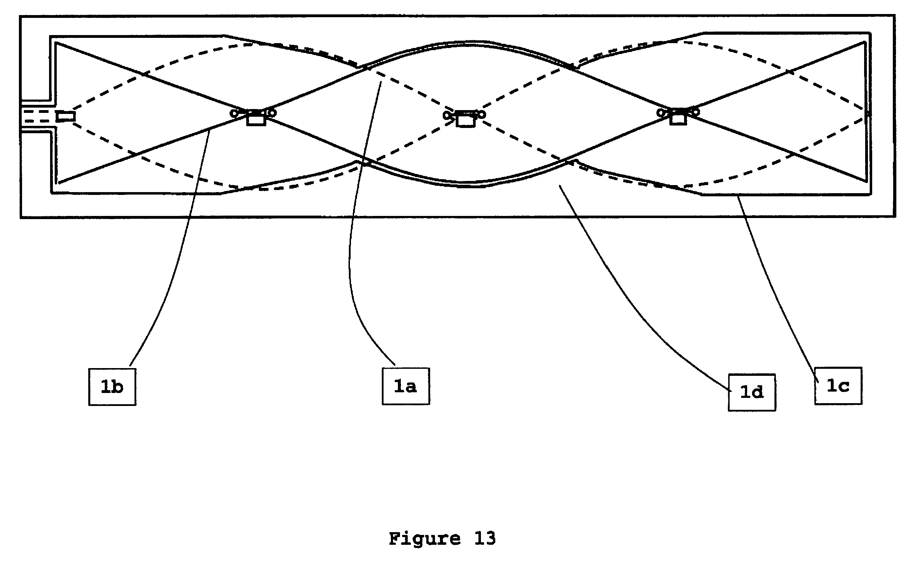

Figure 13 shows a simplified schematic of the embodiment for a linear detector. As in the previous embodiment, the antenna [1] comprises a transmit winding [1c] surrounding two receive windings [1a & 1b] which are spaced apart along the measurement path (i.e. x-axis) by ¼ of their winding pitch. A double sided PCB [1d] comprises a receive winding [1b] substantially on its upper surface (nearest the EID [6]) which is surrounded by a transmit winding [1c] also on the upper surface. Another receive winding [1 a] of slightly larger area than the first receive winding [1b] is located substantially on the lower surface. In this embodiment the receive windings are again spaced apart both along the measurement axis [x-axis] and in an axis at right angles - in this embodiment the z-axis.

To achieve the best linearity it may be necessary to vary the area of the receive windings, for example, by adding to the fundamental sine function with a third or higher harmonic. This can also be used to extend the linear range and flatten out end errors without the need for extending the antenna [1] length (e.g. by adding additional loops at the ends of the receive winding).

In the arrangement shown in Figure 13, the width of the transmit winding [1c] may be varied as an alternative method of providing electrical balance - particularly for the traditionally problematic cosine receive winding [1a]. Further, this does not require overall length to be increased. Since the receive windings [1a & 1b] are essentially on separate layers, gain errors can be removed simply by increasing the width of the winding furthest away from the EID [6].

This particular antenna [1] arrangement is easy and inexpensive to produce; requires only a small amount of PCB material; has few vias or crossings which can be arranged in a straight line and provides an antenna with excellent performance.

### Modifications & Further Embodiments

Previously, the more usual form of inductive detector using a single transmit [1c] and two receive windings [1a & 1b] has been described for clarity. This need not necessarily be the case. As will be appreciated by those skilled in the art, inductive detector antennae such as those described herein, can effectively be used in reverse:- the transmit winding becomes the receive winding, received signals become transmitted signals etc.

The pitch displacement of the receive windings [1a & 1b] described previously in first and second embodiments is not necessarily L/4. This was described for reasons of simplicity to make clear the use of arctan calculations on the two received signals.

Measurement resolution can be improved by the use of multiple pitch windings. If, for example, an electronics circuit produces measurement resolution of 10 bits over a full scale of L this can be improved by arranging the receive windings [1a & 1b] in to multiple pitches of <L. For example, if the windings [1a & 1b] are arranged in 5 pitches each of length L/5 then the measurement resolution will be equivalent to 10 bits over L/5, in other words a five fold improvement in resolution.

One draw back of multi-pitch arrangements is that the measured position is ambiguous rather than absolute. Absolute position measurement can be achieved by the use of a second, coarse pitch arrangement of receive windings [1a & 1b] extending over the full scale. In this way a fine pitch measurement can be produced by measurement over the first winding and a second coarse measurement over the second winding. The two measurements may be combined to produce a high resolution, absolute position measurement.

An alternative scheme to coarse and fine pitch winding arrangements is the use of a Vernier technique. This technique uses two or more multi-pitch receive windings [1a & 1b]. For example, a first pair of windings of pitch 60mm is used with a second pair of windings of 70mm. The ambiguous readings from each pair of windings can be combined to provide absolute measurement. Absolute measurement is preserved up to the lowest common multiple of the pitches - in this example, 420mm.

A further alternative to enable high resolution measurement over extended scales can be achieved with the use of a reed or Hall switch for example. In such an instance a magnet is attached to the EID [6] which triggers the switch to signify that, for example, a second area of the antenna [1] is in operation.

The invention is not limited to the measurement of linear displacement. If the arrangement of the antenna [1] and EID [6] is bent around an axis it can be seen that the invention is readily suitable for the measurement of rotary position. Further the EID [6] and antenna [1] can be arranged for a wide variety of sensing geometries including curvi-linear, 2-dimensional, roll, pitch, yaw, cylindrical and position measurements over complex surfaces. 3-dimensional position measurement can be made using the amplitude of the EID's [6] as an indication of its distance from the plane of the antenna [1]. Alternatively, 3D position measurement may be provided by the use of multiple antenna [1] arranged at right angles to each other.

To a significant extent, variation in the position of the EID [6] relative to the antenna [1] in axes other than the main measurement axis does not affect the measured value. In particular, the stand off distance between EID [6] and antenna [1] in the z-axis can vary without altering the measured displacement. The range of acceptable variation in the z-axis can be extended by adjusting the amplification factors used in the electronics circuit according to the amplitude of the received signals. If the EID [6] to antenna [1] distance is large then the amplitude of received signals will be small and large amplifications should be applied. The converse applies if EID [6] to antenna [1] distance is small.

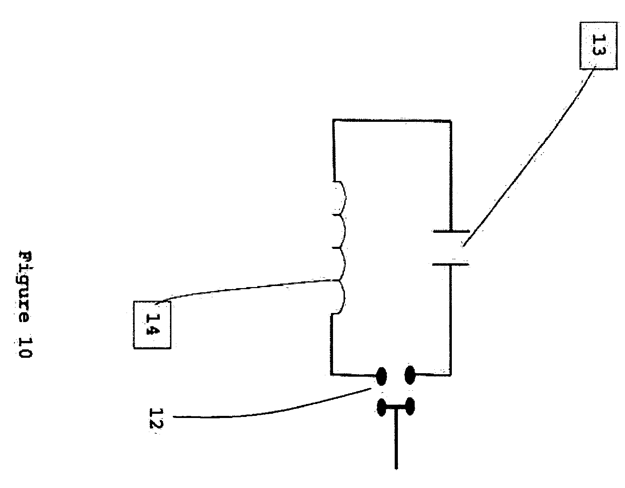

Figure 10 shows a schematic of how the invention may be used as a non-contact method of transmitting switch status. A normally open switch [12] is arranged in series with a resonant EID's capacitor [13] and inductor [14]. When a local antenna [1] is energised, currents will be unable to flow in the EID [6] because of the open circuit and no signal will be received by the antenna [1]. When the switch [12] is closed currents will flow and the antenna [1] will receive a signal. The converse is also true when a normally closed switch is used. Data regarding multiple switches may be provided by using multiple resonant circuits of various resonant frequencies. Alternatively the switches can be used to switch in other capacitors [13] or inductors [14] so as to alter the natural frequency of the EID [6] and hence provide data on switch position.

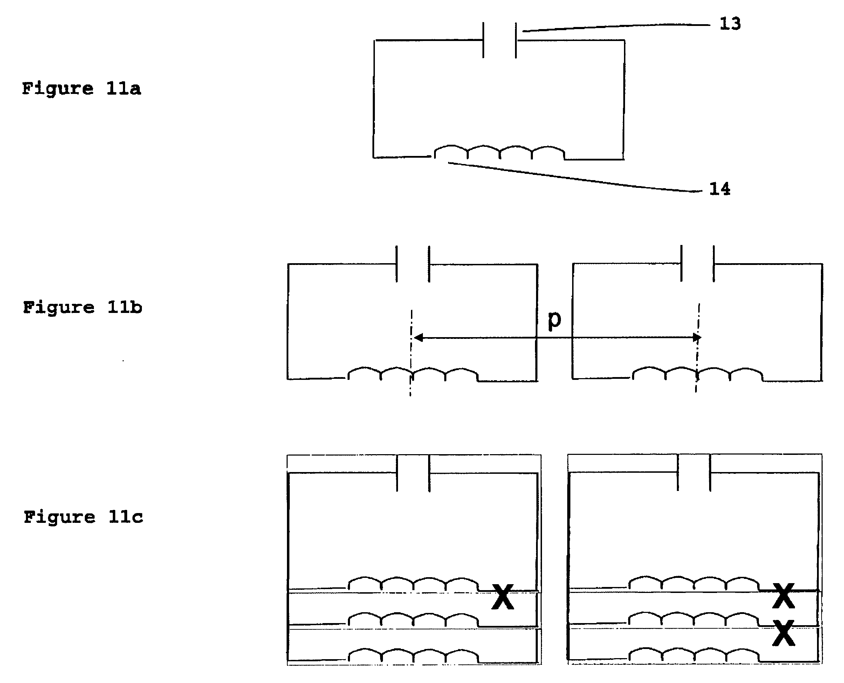

Figures 11a, 11b & 11c schematically show methods of how the invention may be used as an identification method.

In Figure 11a, an inductor [14] and capacitor [13] are arranged in electrical series. Varying either the capacitor [13] or inductor [14] will vary the circuit's natural frequency. This technique can be used as a way of encoding identity against a predetermined set of identities and frequencies held in the electronic circuit's memory. Typically, a practical range of possible frequencies will be limited to about 10 so that tolerances on frequencies can be tolerated and frequency harmonics avoided.

In Figure 11b, 2 resonant circuits are provided. In this way the combination of potential resonant frequencies increases the practical number of possible identities. Further, by varying the distance between the circuits, p, this increases the number of identities still further. Large numbers of identities can be encoded with the use of more than 2 EIDs [6] and 2-dimensional (in x & y-axes) sensing.

Figure 11c shows a schematic of a resonant circuit with inductances in parallel. By obliterating part of one or more of the inductor's [14] at positions marked X then the circuit's inductance is altered and, in turn, the resonant frequency. This can be readily performed using a computer numerically controlled printed circuit board drilling machine and is an alternative method of varying a circuit's frequency compared to changing the value of the capacitor. In this way, resonant circuits can be produced in bulk from a small number of PCB's and capacitors and then tailored to specific identification requirements at point of delivery.

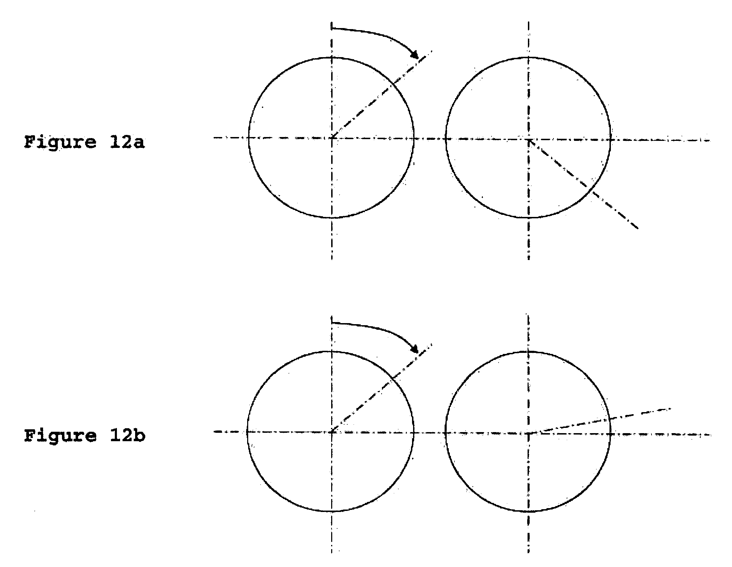

Figure 12a and 12b show a schematic arrangement of two resonant circuits which may be rotated around their respective centre point. The measured positions of the resonant circuits may be taken as a means of identification, rather like moving the dials of a padlock or safe. This is particularly useful for automatic, non-contact measurement of a manual action.

The invention can identify a multiplicity of EIDs [6] and measure their displacement relative to the antenna [1] in a roughly concurrent fashion. Individual resonant frequencies are most readily attained by careful selection of different capacitor [13] values for example to produce 3 EIDs [6] with resonant frequencies of 1, 2 and 4 MHz. The electronics circuit can be programmed to excite at these frequencies in turn and carry out measurements for each EID [6]. In order to maximise the frequency and accuracy of measurements more sophisticated excitation and measurement algorithms can be used. For example, the EID [6] which is found to be generally stationary is measured least and the one that has moved most recently or most often is measured most frequently.

A single electronics circuit may control multiple antennae [1] each co-operating with one or more EIDs [6]. The electronics circuit may use frequency or time based multiplexing and provide electrical outputs accordingly.

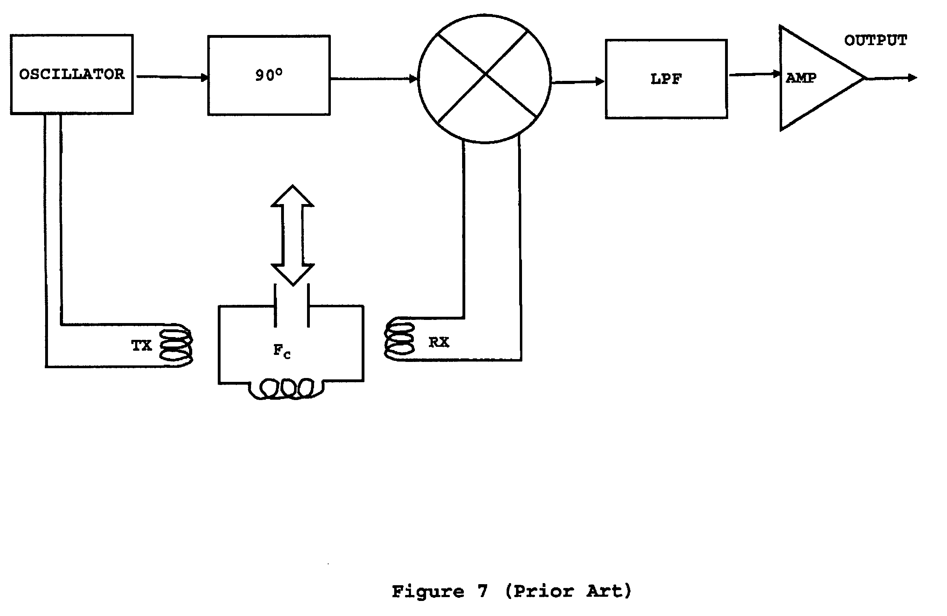

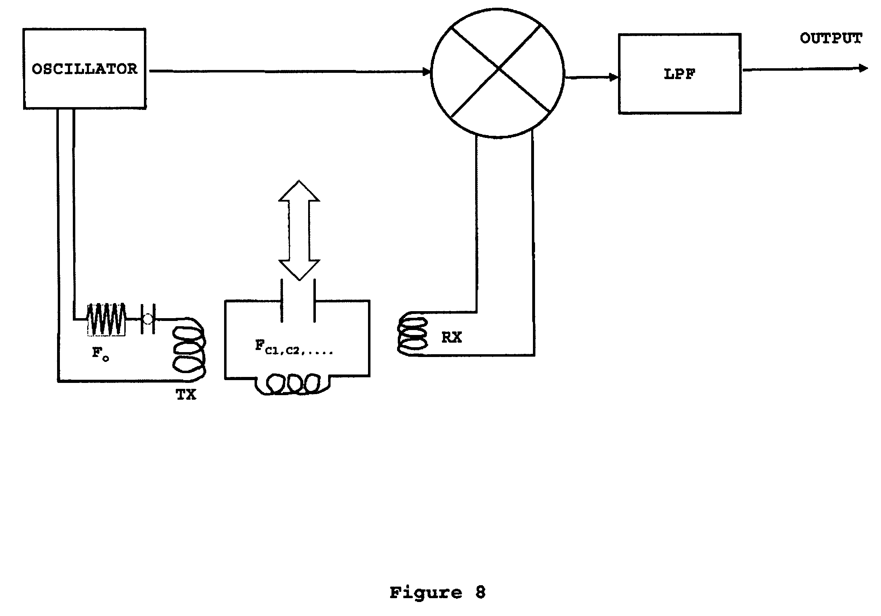

In a further embodiment the invention provides an inductive detector which has particular relevance for applications that require low power consumption, such as battery powered devices. Figure 7 schematically shows a known arrangement of an inductive detector. The electrical schematic is self explanatory. Only one set of transmit [1c] and receive windings [1b] is shown for simplicity. The known system works but its performance and costs are limited in a number of respects. Firstly, detectors of this type are relatively power hungry. Secondly, the cost of the electronics circuit is prohibitively expensive for some high volume, mass market applications. Figure 8 schematically shows this further embodiment of the invention. The electrical schematic is self explanatory. Only one set of transmit [1c] and receive windings [1b] is shown for clarity. The transmit winding [1c] is constructed as a resonant circuit. Accordingly, the detector requires less power than known detector constructions to produce a given strength of magnetic (H) field. Further, the electronics circuit is simplified since the transmit winding [1c] produces a phase shift thereby removing the phase shift required in the electronic circuit's oscillator. Secondly, the detector's gain removes the need for electronic amplification at a given drive power. The transmit winding's [1c] resonant frequency (fₒ) is preferably constructed at substantially the same resonant frequency (f_{c}) as the EID [6] and with a Q of 10 to 30. When multiple EIDs [6] of various resonant frequencies are to be measured then the transmit winding's [1c] resonant Q factor can be artificially reduced by adding a parallel resistance. Alternatively, the transmit resonance frequency (Fₒ) can be made tuneable.

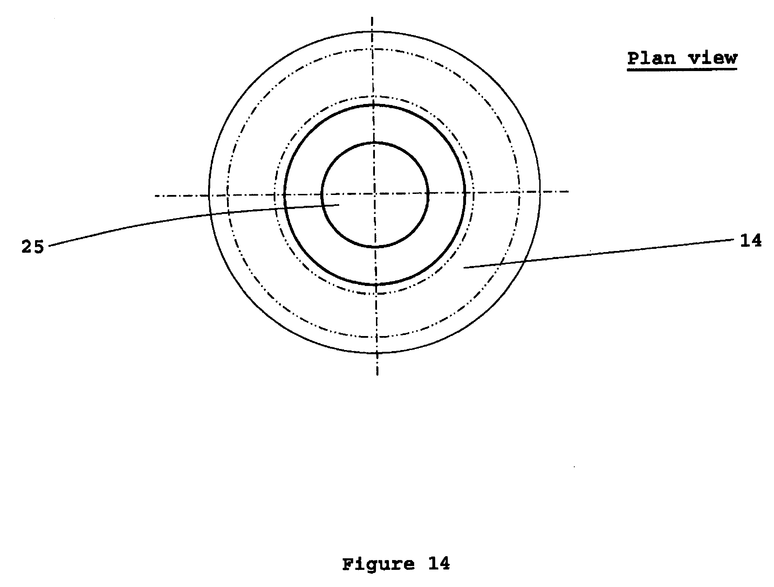

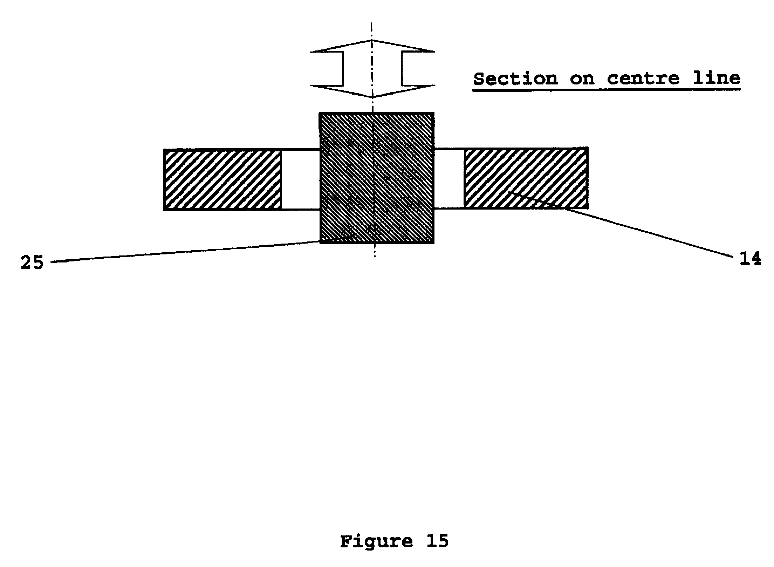

In most instances (but not all) the invention's EID [6] is preferably made from a resonant circuit comprising an inductor [14] and capacitor [13] in series. The inductor [14] is preferably formed as a spiral wound inductor [14] on a PCB as shown in plan view in Figure 14 and in section in Figure 15. When a magnetically permeable element [25] displaces relative to the inductor [14] the inductance value alters. This may be detected by a local antenna [1] as a shift in the resonant frequency of the EID [6]. Such a movement may be produced, for example, by a change in pressure on a component to which the magnetically permeable element [25] is attached; the pressing of the magnetically permeable element [25] by a user or a change in temperature which causes an extension or retraction of the magnetically permeable element [25].

There is no absolute size limitation to the invention. The limits are only set by limits of manufacturing processes rather than physical laws. At one extreme, very large detectors can be produced by winding copper wire over pegs arranged at defined positions. At the other extreme, very small detectors can be produced using deposition of conductive tracks on a silicon wafer.

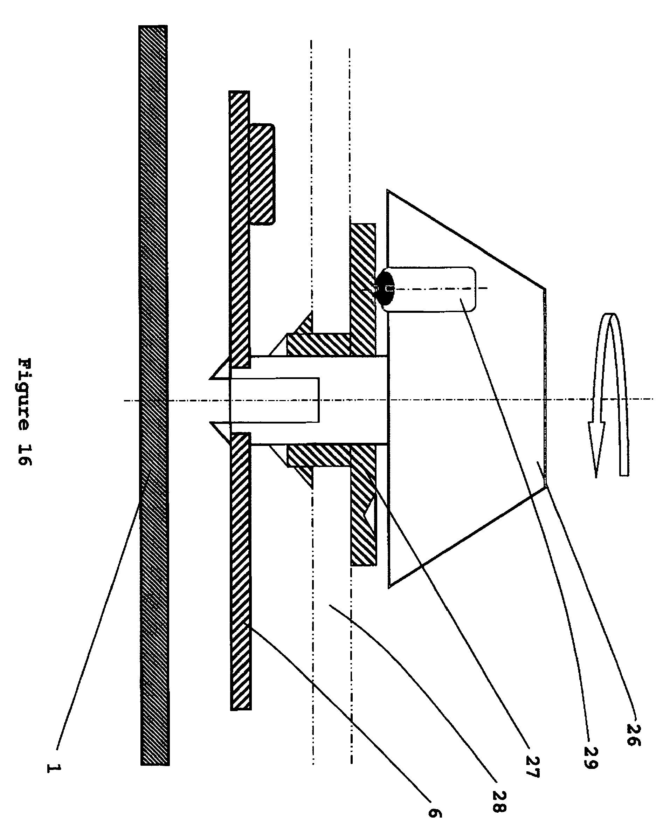

In a further embodiment the invention may be constructed to detect touch from a person or object. Figure 16 shows a sectional view on the centre line of a rotary user element. A conductive knob [26] has a clip feature which holds a EID [6]. The EID [6] comprises at least one resonant circuit. The knob [26] and EID [6] assembly is held in place relative to a fascia panel [28] by a plastic housing [27] clipped to the fascia panel. The plastic housing [27] contains recesses against which a mechanical detent [29] acts to provide the user with tactile feedback. The EID [6] rotates relative to a planar antenna [1]. The antenna [1] is secured relative to the fascia panel [28] but at a distance whereby the metal fascia is outside the antenna's [1] near field.

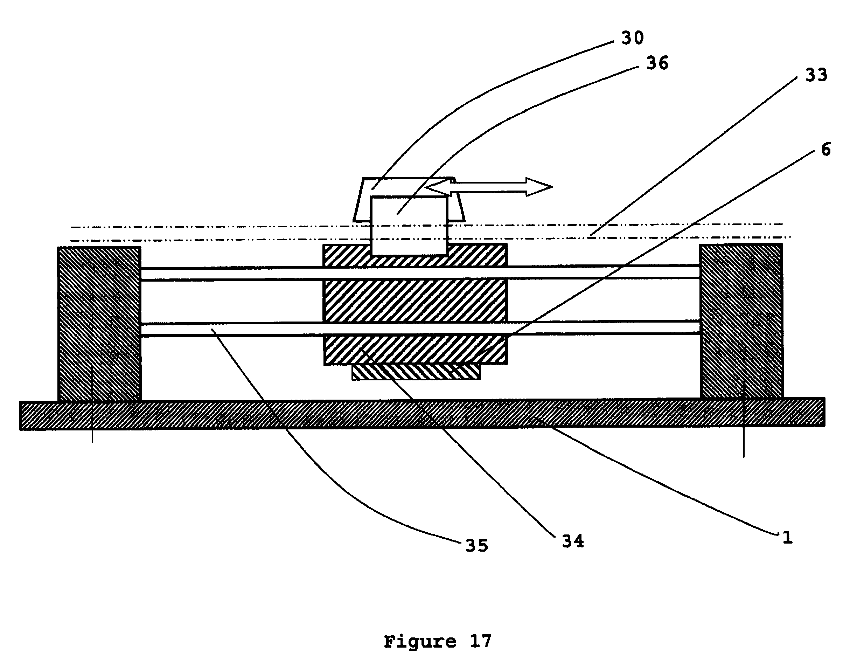

Figure 17 shows a linear embodiment of the invention in which the conductive user element [30] is connected to a plastic moulding [34]. The moulding [34] is arranged such that it slides along 2 linear steel shafts [35]. The shafts [35] are fixed to the antenna [1]. The moulding [34] contains a conductive blade [36] on to which the user element [30] may be fixed. The tactile feel or friction of the moulding [34] running on the shafts [35] may be varied by the selection, presence or absence of a magnet [not shown for clarity] which is attracted to the shafts [35] and so alters the frictional force between the moulding [34] and shafts [35].

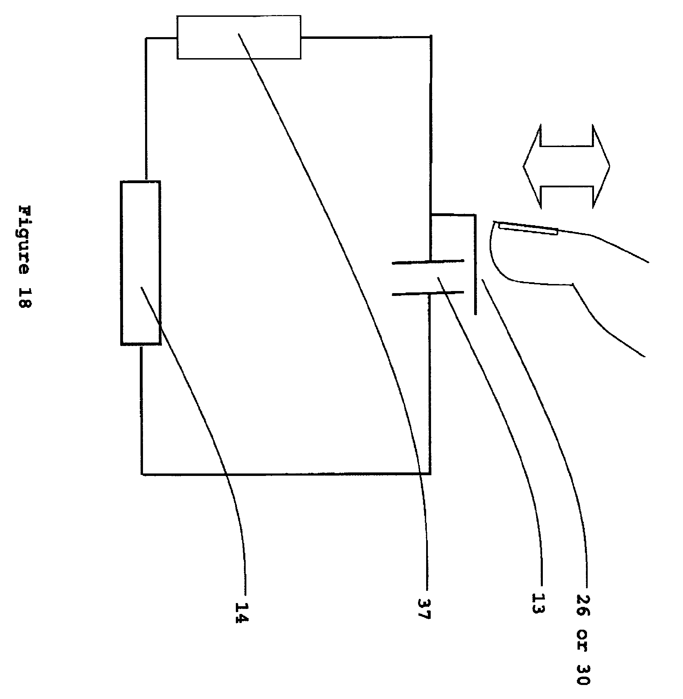

Touch from a user may be detected with the aid of a modified resonant EID [6] connected to the user element [26 or 30]. This modified resonant EID [6] contains a larger second inductor [37] in series with the first inductor winding [14] as shown in Figure 18. The resonant circuit and user element [26 or 30] are arranged such that when a user touches the user element [26 or 30] the user's finger effectively touches the capacitor [13] and produces a reduction in the EID's Q factor and shifts the circuit's resonant frequency. Such a change is readily detected by the antenna [1]. Preferably the place where the person touches is provided by a metallised surface of a plastic injection moulded user element [26 or 30].

The second inductor [37] preferably has a significantly larger inductance than the first inductor winding [14]. This enables the capacitor [13] to be smaller at a given resonant frequency and hence the circuit is more sensitive to touch.

Alternatively, touch may also be detected by using a separate second resonant EID [6] whose frequency is substantially different to the frequency of the first resonant circuit EID [6]. The first EID [6] is used for position measurement. The two EID's are arranged so that if a user touches the user element [26 or 30], only the Q of the second EID reduces. In this way there is no deleterious effect on the signal used to measure position. In both instances, either a change in the signal's Q or resonant frequency may be used as a method of contactlessly measuring a user's touch.

There are many applications for the invention including, but not limited to: actuators, aileron controls, angle sensors, radar antenna tracking, anti-counterfeit devices, audio controls, automatic teller machines, automation equipment, ball screws, boilers, brake sensors, brake wear sensors, burners, climate controls, cockpit controls, component identification, consumer electronics , cookers, cooking ranges, cooktops, dials, direction indicators, dishwashers, displacement sensors, door travel sensors, elevators, end of shaft encoders, fitness equipment, flow sensors, food mixers, fuel level sensors, fuel metering, games, gauges, giant magnetoresistive sensor replacements, guided vehicle tracking, gunnery sights, Hall affect replacements, headlamp level controls, HVAC sensors, hydraulic actuators, hydraulic valves, identification tags, impellers, inclinometers, Inductosyn replacements, industrial control panels, joysticks, kitchen goods, lifts, lighting controls, limit switch replacements, linear actuators, liquid level sensors, load sensors, LVDT replacements, machine tools, magnetostrictive sensor replacements, marine drives, marine controls, marine engines, mining equipment, missile guidance, motion controllers, motor encoders, odometers, packaging equipment, palletisers, paper thickness sensors, pedal sensors, pen sensing, petrochemical sensors, plotter controls, pneumatic actuators, pneumatic valves, pressure sensors, printer write heads, PRNDL sensors, proximity sensors, push buttons, radar controls, ride height sensors, robots, roll/pitch/yaw sensors, roller separation sensors, rotary encoders, RVDT replacements, safety switches, seating instrumentation, security tags, servo motors, shaft encoders, sheet feeders, skis, sliders, speed sensors, sports equipment, steering angle sensor, steering column controls, stepper motors, strain measurement, suspension dampers, suspension sensors, tachometers, tamper evident devices, throttle controls, tilt sensors, torque sensors, toys, traction control, transmission sensors, user interface elements, utility meters, valves, velocity sensors, vibration sensors, washing machines, weight sensors, wheel sensors, workpiece identification.

## Claims

1. An inductive detector operable to measure the relative displacement of two bodies along a measurement path comprising:
a first body comprising an electrical intermediate device (6); and
a second body comprising three windings, one being a transmit winding (1c) and one being a receive winding (1a, 1b), and the third winding being either a transmit winding or a receive winding,
said windings being provided on a substrate having a first surface and a second surface opposite the first surface;
wherein said windings are arranged such that relative displacement of the two bodies causes a change in the inductive coupling between said transmit winding and said receive winding,
**characterised in that** each of the windings of which there are two is formed by a convoluted conductor with a first portion extending along the measurement path on the first surface of the substrate and a second portion returning back along the measurement path on the second surface of the substrate, said first and second portion being connected via a connection extending between the first surface and the second surface, said convoluted conductor forming a series of loops defined between the portion of the conductor on the first surface and the portion of the conductor on the second surface, the width of each loop in varying along said measurement path and adjacent loops having opposite electromagnetic polarity,
and further **characterised in that** the windings of which are two are spaced apart along an axis normal to the measurement path.

2. An inductive detector according to claim 1, wherein the electrical intermediate device is inductively resonant.

3. An inductive detector according to any preceding claim wherein the loops are formed in a generally triangular shape.

4. An inductive detector according to claim 1, wherein the loops are interdigitated in the direction at right angles to the measurement path.

5. An inductive detector according to any preceding claim wherein each series of loops has an enclosed area which is in proportion to its distance from the electrical intermediate device.

6. An inductive detector according to any preceding claim wherein a transformer couples energy to at least one transmit winding (1c) and receives signals from at least one receive winding (1a, 1b).

7. An inductive detector according to claim 6, wherein the angular twist between two points of a rotating elastic shaft is measured.

8. An inductive detector according to either of claims 6 and 7 wherein a substantially impermeable membrane is placed between primary and secondary windings of the transformer.

9. An inductive detector according to any preceding claim where the displacement along the measurement path of the series of loops of one winding to the series of loops of another winding of substantially the same pitch is one quarter of their winding pitch distance.

10. An inductive detector according to any preceding claim, wherein the windings (1a, 1b, 1c) and electrical intermediate device are arranged for relative displacement in a path chosen from one or more of: linear; rotary; curvi-linear; roll; pitch; yaw; 2-dimensional; 2-dimensional+rotary; 3-dimensional.

11. An inductive detector according to claim 2 and any claim dependent thereon, wherein a switch (12) is placed in series with the capacitor and the inductor of the electrical intermediate device and arranged so that the status of the switch may be determined contactlessly.

12. An inductive detector according to claim 2 and any claim dependent thereon, wherein the resonant frequency of the electrical intermediate device (6) is measurably modified by displacement of a magnetically permeable element (25) relative to the inductor (14) of the electrical intermediate device.

13. An inductive detector according to any preceding claim wherein the first body comprises multiple electrical intermediate devices (6), each of which has its own resonant frequency and cooperates with said transmit (1c) and receive windings (1a, 1b).

14. An inductive detector according to any preceding claim, wherein the second body is a board (1d) formed of an insulating substrate material having an upper face and a lower face, and the convoluted conductor from which the series of loops is formed extends along the measurement path on said upper face and returns back along said measurement path on said lower face, electrical connection between said upper and said lower faces being achieved by means of one of: a single via hole, and an edge connector.

## Patentansprüche

1. Induktiver Detektor, der betrieben werden kann, um die relative Verschiebung von zwei Körpern entlang einer Messstrecke zu messen, umfassend:
einen ersten Körper, der ein elektrisches Zwischengerät (6) umfasst; und
einen zweiten Körper, der drei Windungen umfasst, wovon eine eine Sendewindung (1c) und eine eine Empfangswindung (1a, 1b) ist und die dritte Windung entweder eine Sendewindung oder eine Empfangswindung ist,
wobei die Windungen auf einem Träger bereitgestellt sind, der eine erste Oberfläche und eine zweite Oberfläche gegenüber der ersten Oberfläche aufweist;
wobei die Windungen so angeordnet sind, dass die relative Verschiebung der beiden Körper eine Änderung der Kopplung zwischen der Sendewindung und der Empfangswindung bewirkt,
**dadurch gekennzeichnet, dass** jede der Windungen, von denen es zwei gibt, gebildet wird durch einen gewundenen Leiter mit einem ersten Abschnitt, welcher sich entlang der Messstrecke auf der ersten Oberfläche des Trägers erstreckt, und einem zweiten Abschnitt, welcher entlang der Messstrecke auf der zweiten Oberfläche des Trägers zurückkehrt, wobei der erste und der zweite Abschnitt über eine Verbindung verbunden sind, die sich zwischen der ersten Oberfläche und der zweiten Oberfläche erstreckt, wobei der gewundene Leiter eine Reihe von Schleifen bildet, die zwischen dem Abschnitt des Leiters auf der ersten Oberfläche und dem Abschnitt des Leiters auf der zweiten Oberfläche definiert sind, wobei die Breite jeder Schleife entlang der Messstrecke variiert und benachbarte Schleifen eine entgegengesetzte elektromagnetische Polarität aufweisen, und des Weiteren **dadurch gekennzeichnet, dass** die Windungen, von denen es zwei gibt, im Abstand zueinander entlang einer Achse angeordnet sind, welche senkrecht zur Messstrecke verläuft.

2. Induktiver Detektor gemäß Anspruch 1, wobei das elektrische Zwischengerät induktiv resonant ist.

3. Induktiver Detektor gemäß einem der vorherigen Ansprüche, wobei die Schleifen in einer im Allgemeinen dreieckigen Form ausgebildet sind.

4. Induktiver Detektor gemäß Anspruch 1, wobei die Schleifen in der Richtung rechtwinklig zur Messstrecke ineinander greifen.

5. Induktiver Detektor gemäß einem der vorherigen Ansprüche, wobei jede Reihe von Schleifen einen eingeschlossenen Bereich aufweist, der proportional zu seinem Abstand von dem elektrischen Zwischengerät ist.

6. Induktiver Detektor gemäß einem der vorherigen Ansprüche, wobei ein Transformator Energie zu mindestens einer Sendewindung (1 c) koppelt und Signale von mindestens einer Empfangswindung (1a, 1 b) empfängt.

7. Induktiver Detektor gemäß Anspruch 6, wobei der Verdrehwinkel zwischen zwei Punkten einer rotierenden elastischen Welle gemessen wird.

8. Induktiver Detektor gemäß Anspruch 6 oder Anspruch 7, wobei eine im Wesentlichen undurchlässige Membran zwischen den Primär- und Sekundärwicklungen des Transformators platziert ist.

9. Induktiver Detektor gemäß einem der vorherigen Ansprüche, wobei die Verschiebung entlang der Messstrecke der Reihe von Schleifen von einer Windung gegenüber der Reihe von Schleifen von einer anderen Windung mit im Wesentlichen demselben Windungsschritt ein Viertel ihres Windungsschrittabstands beträgt.

10. Induktiver Detektor gemäß einem der vorherigen Ansprüche, wobei die Windungen (1a, 1 b, 1 c) und das elektrische Zwischengerät für die relative Verschiebung in einer Strecke angeordnet sind, die aus einer oder mehreren der folgenden Optionen ausgewählt ist: linear; Rotieren; kurvenlinear; Rollen; Nicken; Gieren, 2-dimensional, 2-dimensional+rotierend, 3-dimensional.

11. Induktiver Detektor gemäß Anspruch 2 und einem davon abhängigen Anspruch, wobei ein Schalter (12) in Reihe mit dem Kondensator und dem Induktor des elektrischen Zwischengeräts geschaltet ist und so angeordnet ist, dass der Status des Schalters kontaktlos ermittelt werden kann.

12. Induktiver Detektor gemäß Anspruch 2 und einem davon abhängigen Anspruch, wobei die Resonanzfrequenz des elektrischen Zwischengeräts (6) durch die Verschiebung eines magnetisch durchlässigen Elements (25) im Verhältnis zum Induktor (14) des elektrischen Zwischengeräts messbar verändert wird.

13. Induktiver Detektor gemäß einem der vorherigen Ansprüche, wobei der erste Körper mehrere elektrische Zwischengeräte (6) umfasst, von denen jedes seine eigene Resonanzfrequenz aufweist und mit den Sende- (1 c) und Empfangswindungen (1a, 1 b) zusammenwirkt.

14. Induktiver Detektor gemäß einem der vorherigen Ansprüche, wobei der zweite Körper eine Platte (1d) ist, die aus einem isolierenden Trägermaterial gebildet ist und eine Oberseite und eine Unterseite aufweist, und der gewundene Leiter, aus dem die Reihe von Schleifen gebildet ist, sich entlang der Messstrecke der Oberseite erstreckt und entlang der Messstrecke auf der Unterseite zurückkehrt, wobei die elektrische Verbindung zwischen der Oberseite und der Unterseite mittels einer der folgenden Optionen erzielt wird: ein einzelnes Kontaktloch und eine Randstiftleiste.

## Revendications

1. Un détecteur inductif utilisable pour mesurer le déplacement relatif de deux corps sur un parcours de mesure comprenant :
un premier corps comportant un dispositif intermédiaire électrique (6) ; et
un deuxième corps comprenant trois enroulements, un étant un enroulement de transmission (1c) et un étant un enroulement de réception (1a, 1b), et le troisième enroulement étant soit un enroulement de transmission, soit un enroulement de réception,
lesdits enroulements étant prévus sur un support ayant une première surface et une deuxième surface opposée à la première surface ;
dans lequel lesdits enroulements sont agencés de telle sorte qu'un déplacement relatif des deux corps entraîne un changement dans le couplage inductif entre ledit enroulement de transmission et ledit enroulement de réception,
**caractérisé en ce que** chacun des enroulements qui sont au nombre de deux est formé par un conducteur enroulé avec une première portion s'étendant sur le parcours de mesure sur la première surface du substrat et une deuxième portion revenant sur le parcours de mesure sur la deuxième surface du substrat, lesdites première et deuxième portions étant connectées via une connexion s'étendant entre la première surface et la deuxième surface, ledit conducteur enroulé formant une série de boucles définies entre la portion du conducteur sur la première surface et la portion du conducteur sur la deuxième surface, la largeur de chaque boucle variant sur ledit parcours de mesure et les boucles adjacentes ayant une polarité électromagnétique opposée,
et en outre **caractérisé en ce que** les enroulements qui sont au nombre de deux sont espacés sur un axe normal par rapport au parcours de mesure.

2. Un détecteur inductif selon la revendication 1, dans lequel le dispositif intermédiaire électrique est à résonance inductive.

3. Un détecteur inductif selon n'importe quelle revendication précédente dans lequel les boucles sont formées dans une forme généralement triangulaire.

4. Un détecteur inductif selon la revendication 1, dans lequel les boucles sont interdigitées dans la direction à angles droits par rapport au parcours de mesure.

5. Un détecteur inductif selon n'importe quelle revendication précédente dans lequel chaque série de boucles a une zone enfermée qui est proportionnelle à sa distance depuis le dispositif intermédiaire électrique.

6. Un détecteur inductif selon n'importe quelle revendication précédente dans lequel un transformateur couple de l'énergie à au moins un enroulement de transmission (1c) et reçoit des signaux d'au moins un enroulement de réception (1a, 1b).

7. Un détecteur inductif selon la revendication 6, dans lequel la torsion angulaire entre deux points d'un arbre élastique rotatif est mesurée.

8. Un détecteur inductif selon n'importe lesquelles des revendications 6 et 7 dans lequel une membrane substantiellement imperméable est placée entre les enroulements primaire et secondaire du transformateur.

9. Un détecteur inductif selon n'importe quelle revendication précédente où le déplacement sur le parcours de mesure de la série de boucles d'un enroulement à la série de boucles d'un autre enroulement faisant essentiellement le même pas est un quart de leur distance de pas d'enroulement.

10. Un détecteur inductif selon n'importe quelle revendication précédente, dans lequel les enroulements (1a, 1b, 1c) et le dispositif intermédiaire électrique sont agencés pour un déplacement relatif sur un parcours choisi parmi un ou plusieurs des parcours suivants :
linéaire ; rotatoire ; curvilinéaire ; rouleau ; pas ; lacet ; bidimensionnel ;
bidimensionnel+rotatoire ; tridimensionnel.

11. Un détecteur inductif selon la revendication 2 et n'importe quelle revendication dépendante de celle-ci, dans lequel un commutateur (12) est placé en série avec le condensateur et l'inducteur du dispositif intermédiaire électrique et agencé de sorte que le statut du commutateur puisse être déterminé sans contact.

12. Un détecteur inductif selon la revendication 2 et n'importe quelle revendication dépendante de celle-ci, dans lequel la fréquence de résonance du dispositif intermédiaire électrique (6) est modifiée de façon mesurable par déplacement d'un élément magnétiquement perméable (25) relativement à l'inducteur (14) du dispositif intermédiaire électrique.

13. Un détecteur inductif selon n'importe quelle revendication précédente dans lequel le premier corps comprend des dispositifs intermédiaires électriques multiples (6), ayant chacun sa propre fréquence de résonance et coopérant avec lesdits enroulements de transmission (1c) et de réception (1a, 1b).

14. Un détecteur inductif selon n'importe quelle revendication précédente, dans lequel le deuxième corps est une planchette (1d) formée d'un matériau de substrat isolant ayant une face supérieure et une face inférieure, et le conducteur enroulé à partir duquel la série de boucles est formée s'étend sur le parcours de mesure sur ladite face supérieure et revient sur ledit parcours de mesure sur ladite face inférieure, une connexion électrique entre lesdites faces supérieure et inférieure étant obtenue par l'un des moyens suivants : un trou d'interconnexion unique, et un connecteur plat.
